(19) Europäisches Patentamt
European Patent Office
Office européen des brevets

(11) **EP 1 329 696 B1**

(12) **EUROPÄISCHE PATENTSCHRIFT**

(45) Veröffentlichungstag und Bekanntmachung des Hinweises auf die Patenterteilung:
**16.07.2008  Patentblatt 2008/29**

(51) Int Cl.:
*G01D 5/347* *(2006.01)*     *H03M 1/28* *(2006.01)*
*G01D 5/249* *(2006.01)*

(21) Anmeldenummer: **02026729.0**

(22) Anmeldetag: **30.11.2002**

(54) **Positionsmesseinrichtung mit Masstab**

Absolute position detector with scale

Détecteur de position absolue avec échelle

(84) Benannte Vertragsstaaten:
**AT BE BG CH CY CZ DE DK EE ES FI FR GB GR IE IT LI LU MC NL PT SE SK TR**

(30) Priorität: **17.01.2002  DE 10201496**

(43) Veröffentlichungstag der Anmeldung:
**23.07.2003  Patentblatt 2003/30**

(73) Patentinhaber: **Dr. Johannes Heidenhain GmbH 83292 Traunreut (DE)**

(72) Erfinder:
• **Mayer, Elmar**
  **83365 Nussdorf (DE)**
• **Benner, Ulrich**
  **83308 Trostberg (DE)**

(56) Entgegenhaltungen:
**EP-A- 0 635 700**          **GB-A- 2 297 840**
**US-A- 4 774 494**

**Beschreibung**

Die vorliegende Erfindung betrifft eine Positionsmesseinrichtung zur absoluten Positionsbestimmung nach dem Oberbegriff des Anspruchs 1.

Zur Positionsbestimmung zueinander beweglicher Objekte sind inkrementale Positionsmesseinrichtungen bekannt, die Relativbewegungen der Objekte zueinander in bestimmten Messschritten bzw. Inkrementen erfassen. Die hierzu eingesetzten inkrementalen Positionsmesseinrichtungen umfassen in der Regel einen Maßstab mit einer Spur mit einer inkrementalen Messteilung, der mit einem der beiden Objekte verbunden ist sowie eine Abtasteinheit, die mit dem anderen der beiden Objekte verbunden ist. Durch eine optische, magnetische, induktive oder kapazitive Abtastung werden in bekannter Art und Weise verschiebungsabhängige, periodische Inkrementalsignale erzeugt.

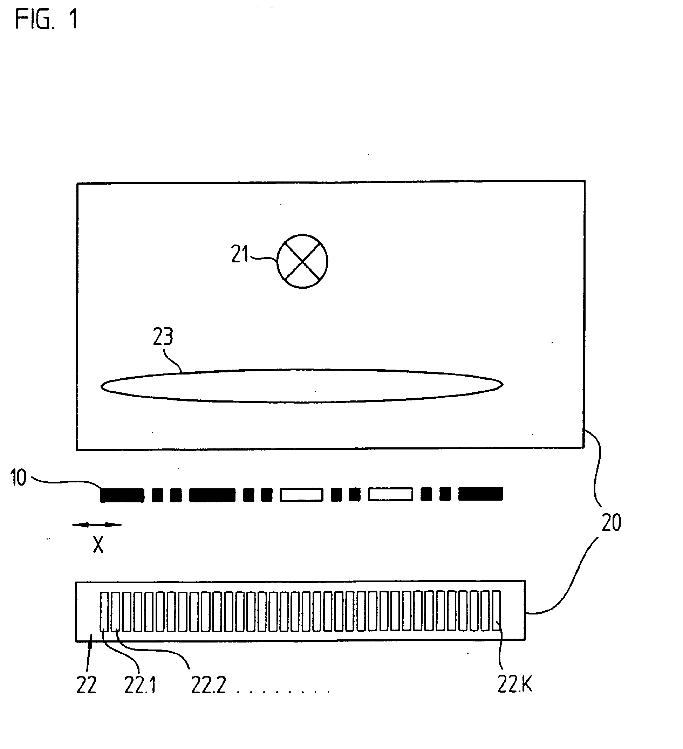

Daneben sind sog. absolute Positionsmesseinrichtungen bekannt, die auf der Maßstabseite eine Spur mit einem sequentiellen Code aus mehreren Bitworten umfassen, z.B. ausgebildet als Pseudo-Random-Code, aus deren Abtastung die Absolutposition entlang der jeweiligen Messstrecke bestimmt werden kann. Der jeweilige sequentielle Code entlang der Messrichtung besteht hierbei aus einer entsprechend gewählten Abfolge logischer Signale bzw. Bits, die z.B. die Werte NULL (0) und EINS (1) annehmen. Zur Erhöhung der Detektionssicherheit ist in derartigen Systemen nunmehr bekannt, jedes einzelne logische Signal bzw. Bit eines Bitwortes aus einer vorgegebenen Abfolge zweier Teilbereiche mit unterschiedlichen optischen Eigenschaften abzuleiten. So entspricht z.B. das logische Signal NULL (0) der Abfolge eines durchlässigen und eines nicht-durchlässigen Teilbereiches, das logische Signal EINS (1) hingegen entspricht der Abfolge eines nicht-durchlässigen und eines durchlässigen Teilbereiches in der Spur. Eine derartige Codierung wird als Manchester-Codierung bezeichnet; hierzu sei z.B. auf die Figur 1 in der Veröffentlichung "Absolute position measurement using optical detection of coded patterns", J. T. M. Stevenson, J. R. Jordan, J. Phys. E: Sci. Instrum. 21 (1988), S. 1140- 1145 verwiesen.

Bei der Verwendung derartiger Manchester-Codierungen in absoluten Positionsmesseinrichtungen resultieren zwei typische Problemkomplexe. Zunächst sollte grundsätzlich sichergestellt sein, dass die Teilbereiche korrekt ausgelesen werden bzw. die hierzu eingesetzten Detektorelemente korrekt ausgewählt werden, um einer bestimmten Abfolge von zwei Teilbereichen auch das korrekte logische Signal bzw. den korrekten Bitwert NULL (0) oder EINS (1) zuzuordnen. In Bezug auf dieses Problem liefert die o.g. Publikation keine weiteren Hinweise. Desweiteren ist die über eine Manchester-Codierung generierte absolute Positionsinformation in Bezug auf die Auflösung nicht fein genug. Das heißt, es ist in der Regel vorgesehen, die absolute Positionsinformation mit einer Positionsinformation aus einer höher auflösenden inkrementalen Positionsmessung zu kombinieren. Um aus der grob auflösenden absoluten Code-Information eine höher auflösende Positionsinformation zu erzeugen, die mit der inkrementalen Positionsmessung kombinierbar ist, werden im gerade abgetasteten Codewort zunächst mittels Kanteninterpolation die Übergänge zwischen verschiedenen Teilbereichen und damit eine Grobposition innerhalb des jeweiligen Codewortes bestimmt, mit der dann die Inkrementalinformation kombiniert wird. Ein derartiges Vorgehen wird etwa auch in der o.g. Veröffentlichung vorgeschlagen. Als problematisch erweist sich hierbei, dass die resultierende Genauigkeit einer derartigen Kanteninterpolation durch Beugungseffekte sowie die evtl. vorhandene Divergenz der Lichtquelle negativ beeinflusst wird, so dass Fehler bei der Positionsbestimmung resultieren können. Dies ist insbesondere dann der Fall, wenn höher auflösende Positionsmesseinrichtungen mit geringen Breiten der Teilbereiche eingesetzt werden.

Aus der EP 0 635 700 A1 ist eine gattungsgemäße Positionsmesseinrichtung bekannt, bei der eine absolute Positionsinformation aus der Abtastung einer einzigen codierten Spur generiert wird. Eines der Ausführungsbeispiele offenbart hierbei eine codierte Spur mit drei unterschiedlichen Teilbereichen.

Eine Positionsmesseinrichtung zur absoluten Positionsbestimmung ist ferner aus der GB 2 297 840 A bekannt. Hierbei kommt parallel zu einer pseudo-random codierten Spur eine weitere Spur mit drei verschiedenen Teilbereichen zum Einsatz.

Die Druckschrift US 4,774,494 offenbart eine weitere Variante einer Teilung mit drei verschiedenen Teilbereichen, wobei diese unterschiedliche Farben aufweisen. Die vorgeschlagene Teilung wird jedoch in einer inkrementalen Positionsmesseinrichtung eingesetzt.

Aufgabe der vorliegenden Erfindung ist es, eine Positionsmesseinrichtung anzugeben, die zur absoluten Positionsbestimmung geeignet ist und bei der aus einer einzigen Spur ein sicher auslesbares Absolutpositionssignal mit hoher Auflösung gewonnen werden kann.

Diese Aufgabe wird gelöst durch eine Positionsmesseinrichtung mit den kennzeichnenden Merkmalen des Anspruches 1.

Vorteilhafte Ausführungsformen der erfindungsgemäßen Positionsmesseinrichtung ergeben sich aus den Maßnahmen, die in den von Anspruch 1 abhängigen Ansprüchen aufgeführt sind.

Erfindungsgemäß ist nunmehr vorgesehen, auf der Maßstabseite insgesamt mindestens drei Teilbereiche mit unterschiedlichen optischen Eigenschaften in einer Spur einzusetzen. Hierbei wird einer ersten Kombination zweier aufeinanderfolgender, unterschiedlicher Teilbereiche eindeutig ein erstes logisches Signal zugeordnet ist und einer zweiten Kombination zweier aufeinanderfolgender, unterschiedlicher Teilbereiche eindeutig ein zweites logisches Signal zugeordnet ist. Die erste und die zweite Kombination unterscheiden sich voneinander.

Über diese Maßnahmen ist nunmehr eine eindeutige Codierung der gerade ausgelesenen Bitwort-Position sichergestellt, ohne dass hierzu weitere Informationen benötigt werden. Hinzu kommt, dass darüber auch eine Erkennung eventueller falsch ausgelesener Signale gewährleistet werden kann.

Aufgrund der periodischen Anordnung einer der Teilbereiche auf dem Maßstab lässt sich über entsprechende abtastseitige Maßnahmen sicherstellen, dass neben der Absolutpositionsinformation desweiteren zumindest ein Grob-Inkrementalsignal erzeugbar ist, das zur Bildung eines hoch auflösenden absoluten Positionswertes herangezogen werden kann. Eine Kanteninterpolation - wie oben erläutert - ist in diesem Fall nicht erforderlich, d.h. es lassen sich auf Basis der erfindungsgemäßen Überlegungen nunmehr auch hoch auflösende Positionsmesseinrichtungen realisieren.

Grundsätzlich kann jeder der drei verschiedenen Teilbereiche periodisch auf dem Maßstab angeordnet werden, d.h. sowohl die ersten, zweiten oder dritten Teilbereiche.

Im Hinblick auf die Ausbildung der dritten Teilbereiche existieren verschiedene Möglichkeiten, wenn die ersten und zweiten Teilbereiche komplementäre optische Eigenschaften aufweisen. So kann etwa in einer möglichen Variante für die dritten Teilbereiche eine optische Eigenschaft gewählt werden, die zwischen den optischen Eigenschaften der komplementär ausgebildeten ersten und zweiten Teilbereiche liegt. In einer weiteren Variante weisen die dritten Teilbereiche eine periodische Substruktur auf, aus der sich ein zusätzliches Fein-Inkrementalsignal ableiten lässt, das zur nochmaligen Erhöhung der Auflösung bei der absoluten Positionsbestimmung dient.

Auf der Abtastseite ist zur Erzeugung der verschiedenen Abtastsignale aufgrund der erfindungsgemäßen Maßnahmen in einer möglichen Ausführungsform lediglich eine einzige Detektoranordnung mit mehreren Detektorelementen erforderlich, über die sämtliche Abtastsignale erzeugbar sind.

Die vorliegende Erfindung lässt sich selbstverständlich in Durchlicht-Systemen wie auch in Auflicht-Systemen einsetzen; ebenso können sowohl lineare wie auch rotatorische Positionsmesseinrichtungen erfindungsgemäß ausgebildet werden. Desweiteren lassen sich die erfindungsgemäßen Überlegungen auch auf Systeme übertragen, die auf Seiten des Maßstabes mehr als drei verschiedene Teilbereiche umfassen.

Weitere Vorteile sowie Einzelheiten der vorliegenden Erfindung ergeben sich aus der nachfolgenden Beschreibung von Ausführungsbeispielen anhand der beiliegenden Figuren.

Dabei zeigt

Figur 1        eine schematisierte Ansicht eines ersten Ausführungsbeispieles der erfindungsgemäßen Positionsmesseinrichtung mit einer ersten Variante eines geeigneten Maßstabes in Verbindung mit einer Abtasteinheit;

Figur 2        eine Draufsicht auf einen Teil eines zweiten Ausführungsbeispiels eines geeigneten Maßstabes in Verbindung mit einer schematisiert angedeuteten Detektoranordnung;

Figur 3a      ein erstes Blockschaltbild zur Erläuterung der Verarbeitung der über die Detektoranordnung in Figur 2 erzeugten Signale;

Figur 3b      ein zweites Blockschaltbild zur Erläuterung der Verarbeitung der über die Detektoranordnung in Figur 2 erzeugten Signale;

Figur 4        eine Draufsicht auf einen Teil eines dritten Ausführungsbeispiels eines geeigneten Maßstabes in Verbindung mit einer schematisiert angedeuteten Detektoranordnung;

Figur 5        ein Blockschaltbild zur Erläuterung der Verarbeitung der über die Detektoranordnung in Figur 4 erzeugten Signale;

Figur 6a - 6c   jeweils die aus dem in Fig. 4 gezeigten Maßstabsbereich generierten Signale.

In Figur 1 ist in schematisierter Form ein erstes Ausführungsbeispiel einer erfindungsgemäßen Positionsmesseinrichtung inclusive eines ersten Ausführungsbeispiels eines geeigneten Maßstabes dargestellt. Die Positionsmesseinrichtung - ausgebildet als lineares Durchlichtsystem - umfasst hierbei einen Maßstab 1, dessen konkrete Ausbildung im Verlauf der nachfolgenden Beschreibung noch detailliert erläutert wird, sowie eine relativ zum Maßstab 1 in mindestens einer Messrichtung x bewegliche Abtasteinheit 20. Auf Seiten der Abtasteinheit 20 ist eine Lichtquelle 21, eine Kollimatoroptik 23 sowie eine Detektoranordnung 22 angeordnet, die aus einer Vielzahl k einzelner Detektorelemente 22.1, 22.2, ... 22.k besteht, die in Messrichtung x periodisch angeordnet sind. Als Lichtquelle 21 kommt an dieser Stelle etwa eine LED in Betracht, als Detektoranordnung 22 dient ein Fotodiodenarray mit k benachbarten Detektorelementen 22.1,....22.k.

Der Maßstab 1 und die Abtasteinheit 20 der Positionsmesseinrichtung sind mit zwei zueinander in Messrichtung x beweglichen Objekten verbunden, deren Position zueinander zu bestimmen ist. Bei den beiden Objekten kann es sich z.B. um Werkzeug und Werkstück in einer numerisch gesteuerten Werkzeugmaschine handeln. Mit Hilfe der erfindungsgemäßen Positionsmesseinrichtung lässt sich über eine photoelektrische Abtastung des Maßstabes 1 und die nachfolgende Kombination der verschiedenen, erzeugten Abtastsignale eine hochauflösende absolute Positionsinformation $POS_{ABS}$ generieren. Als Abtastsignale resultieren ein Absolutpositionssignal ABS, ein Grob-Inkrementalsignal $INC_G$ sowie ein Fein-Inkrementalsignal $INC_F$, was nachfolgend noch im Detail erläutert wird. Die Kombination der verschiedenen Abtastsignale zu einer absoluten Positionsinformation $POS_{ABS}$ kann sowohl direkt in der erfindungsgemäßen Positionsmesseinrichtung erfolgen als auch erst in einer nachgeordneten - nicht dargestellten - Auswerteeinheit vorgenommen werden, der die verschiedenen Abtastsignale zugeführt werden. Bei einer derartigen Auswerteeinheit kann es sich beispielsweise um eine numerische Werkzeugmaschinensteuerung handeln.

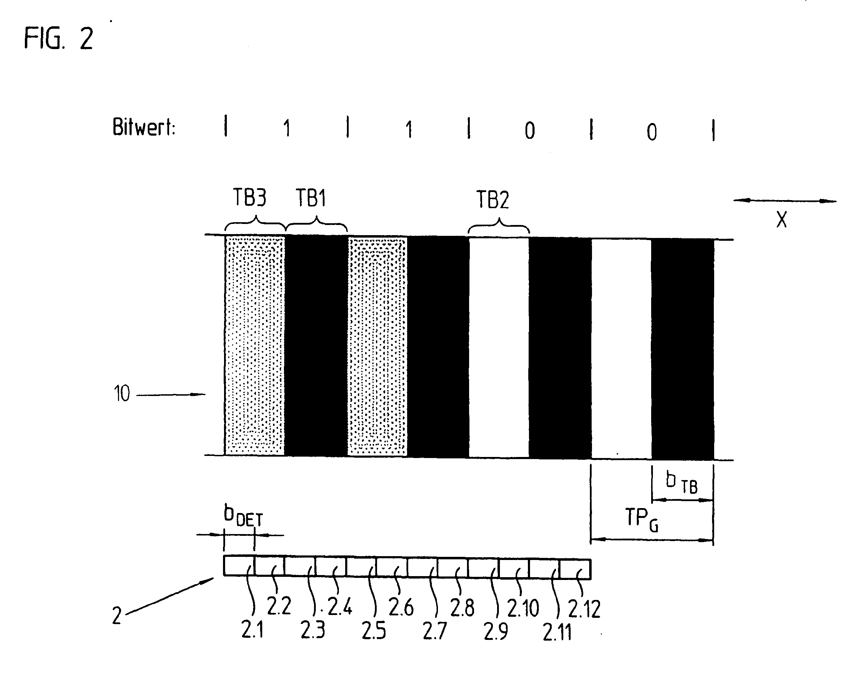

Zur weiteren Beschreibung eines konkreten Ausführungsbeispiels eines geeigneten Maßstabes sei nunmehr auf die Figur 2 verwiesen, die eine Draufsicht auf einen Teil eines Maßstabes 10 in Verbindung mit einer schematisch angedeuteten, zur Abtastung geeigneten Detektoranordnung 2 zeigt. Wie aus der Figur 2 erkennbar, weist der Maßstab 10 entlang der Messrichtung x angeordnete erste, zweite und dritte Teilbereiche TB1, TB2, TB3 auf, die in Messrichtung x alle die gleiche Breite $b_{TB}$, aber unterschiedliche optische Eigenschaften besitzen. Im vorliegenden Beispiel eines Maßstabes 10 für ein Durchlichtsystem sind die ersten Teilbereiche TB1 opak ausgebildet, die zweiten Teilbereiche TB2 vollständig durchlässig. Desweiteren ist erfindungsgemäß eine dritte Kategorie von Teilbereichen TB3 maßstabseitig vorgesehen. Die dritten Teilbereiche TB3 besitzen eine wiederum unterschiedliche optische Eigenschaft zu den ersten und zweiten Teilbereichen TB1, TB2. Im Ausführungsbeispiel der Figur 2 sind die dritten Teilbereiche TB3 halbdurchlässig ausgebildet und besitzen somit eine optische Eigenschaft, die hinsichtlich der optischen Transmissionscharakteristik zwischen den Transmissionscharakteristika der ersten und zweiten Teilbereiche TB1, TB2 liegt. Diese weisen aufgrund der erwähnten opaken bzw. vollständig durchlässigen Ausbildung zueinander komplementäre optische Eigenschaften auf.

Im Beispiel der Figur 2 sind die ersten Teilbereiche TB1 entlang der Messrichtung x periodisch auf dem Maßstab 10 angeordnet. Deren Periode sei nachfolgend als Grob-Teilungsperiode $TP_G$ bezeichnet und entspricht vorzugsweise der doppelten Breite $b_{TB}$ der Teilbereiche TB1, TB2, TB3, d.h.

$$TP_G = 2 * b_{TB} \qquad (Gl.\ 1).$$

Der dargestellte Maßstab 10 weist prinzipiell eine sog. Manchester-Codierung auf. Dies bedeutet i.w., dass zwei unterschiedlichen Kombinationen zweier aufeinanderfolgender, unterschiedlicher Teilbereiche TB3, TB1 bzw. TB2, TB1 jeweils eindeutig ein logisches Signal zugeordnet ist. Im vorliegenden Beispiel ist einer ersten Kombination aus aufeinanderfolgenden dritten und ersten Teilbereichen TB3, TB1 das erste logische Signal EINS (1) zugeordnet, einer zweiten Kombination von aufeinanderfolgenden zweiten und ersten Teilbereichen TB2, TB1 das zweite logische Signal NULL (0). Über den in Figur 2 dargestellten Ausschnitt des Massstabes 10 ergibt sich somit von links ausgehend als Abfolge der verschiedenen logischen Signale wie angegeben die Bitfolge bzw. das Bitwort 1; 1; 0; 0; usw.. Über eine derartige Abfolge mehrerer logischer Signale NULL (0) und EINS (1) lässt sich entlang des Maßstabes 10 in Messrichtung x in bekannter Art und Weise eine eindeutige Absolutposition als Codewort charakterisieren bzw. ein Absolutpositionssignal ABS erzeugen. Beispielsweise kann eine derartige Abfolge mehrer logischer Signale einer Pseudo-Random-Codierung entsprechen, aus der sich eine definierte Absolutposition entlang des Maßstabes 10 ableiten lässt.

Im Falll des erläuterten Durchlichtsystems handelt es sich bei den unterschiedlichen optischen Eigenschaften der verschiedenene Teilbereiche TB1, TB2, TB3 um unterschiedliche optische Durchlässigkeiten; die ersten und zweiten Teilbereiche TB1, TB2 weisen hierbei zueinander komplementäre optische Eigenschaften auf, was wiederum die Ausbildung der ersten Teilbereiche TB1 als vollständig opak bzw. der zweiten Teilbereiche TB2 als vollständig durchlässig zur Folge hat. Alternativ zur erläuterten Ausbildung des Durchlichtsystems kann selbstverständlich die Ausbildung der Teilbereiche TB1, TB2 als vollständig opake Teilbereiche bzw. vollständig durchlässige Teilbereiche auch umgekehrt zur erläuterten Variante erfolgen.

Desweiteren ist es möglich, die erfindungsgemäßen Prinzipien auch auf ein Auflichtsystem zu übertragen. Dies hätte zur Folge, dass es sich bei den unterschiedlichen optischen Eigenschaften dann um unterschiedliche optische Reflexionseigenschaften der Teilbereiche TB1, TB2 handelt. Beispielsweise wären dann die ersten Teilbereiche TB1 nicht-reflektierend ausgebildet, die zweiten Teilbereiche TB2 hingegen reflektierend oder umgekehrt. Entsprechend wäre die optische Eigenschaft der dritten Teilbereiche TB3 so zu wählen, dass diese eine Reflexionscharakteristik aufweisen, die zwischen derjenigen der erste und zweiten Teilbereiche TB1, TB2 liegt, also beispielsweise halbreflektierend ausgebildet ist.

Darüberhinaus gibt es im Rahmen der vorliegenden Erfindung noch weitere Möglichkeiten zur Realisierung der unterschiedlichen optischen Eigenschaften der drei Teilbereiche TB1 - TB3. So könnten diese etwa auch unterschiedliche Farben besitzen. Ferner wäre es möglich, diese mit periodischen Teilungs-Substrukturen auszubilden, die jeweils unterschiedliche Teilungs-Verhältnisse aufweisen usw..

Desweiteren ist es alternativ auch möglich, die logischen Signale NULL (0) und EINS (1) anderen Kombinationen der Abfolge zweier aufeinanderfolgender Teilbereiche zuzuordnen als dies im obigen Beispiel erläutert wurde.

Zur Abtastung des Maßstabes 10 ist auf Seiten der Abtasteinheit eine Detektoranordnung 2 vorgesehen, die eine Reihe von in Messrichtung x periodisch angeordneten Detektorelementen 2.1 - 2.12 umfasst. Im vorliegenden Beispiel umfasst die Detektoranordnung 2 insgesamt zwölf Detektorelemente 2.1 - 2.12, die in Messrichtung jeweils eine Breite $b_{DET} = b_{TB}/2$ besitzen, die der halben Breite $b_{TB}$ der Teilbereiche TB1 - TB3 auf dem Maßstab 10 entspricht.

Bei der Abtastung des Maßstabes 10 resultieren für die verschiedenen Teilbereiche TB1 - TB3 auf Seiten der Detektorelemente 22.1 - 22.6 definierte Signalwerte bzw. Signalpegel, wobei zur nachfolgenden Erläuterung den einzelnen Teilbereichen TB1 - TB3 folgende detektorseitige Signalpegel zugeordnet seien:

TB1: Signalpegel 0

TB2: Signalpegel 1

TB3: Signalpegel 0.5

Im dargestellten Beispiel der Figur 2 liefern demzufolge die Detektorelemente 2.1, 2.2 den Signalpegel 0.5, die Detektorelemente 2.3, 2.4 den Signalpegel 0, die Detektorelemente 2.9, 2.10 den Signalpegel 1 etc.. Vorgegebenen Kombinationen aus zwei in Messrichtung x aufeinanderfolgenden Signalpegeln unterschiedlicher Teilbereiche sind nunmehr bestimmte logische Signale NULL (0), EINS (1) zugeordnet. Hierbei gelten folgende Zuordnungsregeln:

Signalpegel 0.5 - Signalpegel 0 ⇒ logisches Signal EINS (1) (TB3 - TB1)
Signalpegel 1 - Signalpegel 0 ⇒ logisches Signal NULL (0) (TB2 - TB1)
Schaltungstechnisch werden die Zuordnungsregeln in diesem Beispiel so umgesetzt, dass stets die Differenz aus den Signalpegeln benachbarter Teilbereiche TB1 - TB3 erzeugt wird und das resultierende Differenzsignal DIF gemäß den folgenden Vorschriften eindeutig einem der beiden logischen Signale NULL (0) oder EINS (1) zugeordnet wird:

0 < DIF < 0.75 => logisches Signal EINS (1)
0.75 < DIF < 1.0 => logisches Signal NULL (0)

Resultiert ein Differenzsignal DIF abweichend von den beiden angegebenen Wertebereichen d.h. beispielsweise DIF < 0, so wird dies als Fehler bei der Auswahl der korrekten Detektorelemente 2.1 - 2.12 interpretiert. So liefert etwa das Auslesen eines aufeinanderfolgenden ersten und dritten Teilbereiches TB1, TB3 ein Differenzsignal mit dem Wert DIF = -0.5, analog hierzu liefern aufeinanderfolgende erste und zweite Teilbereiche TB1, TB2 ein Differenzsignal mit dem Wert DIF = -1. In beiden Fällen kann aufgrund der erfindungsgemäßen Maßnahmen grundsätzlich durch die alleinige Bildung des Differenzsignales DIF ohne weitere Zusatzinformation verifiziert werden, ob die Detektorelemente korrekt ausgewählt wurden.

Selbstverständlich sind im Rahmen der vorliegenden Erfindung alternativ zu den erläuterten Zuordnungsregeln und -vorschriften auch alternative Regeln verwendbar.

Aufgrund der maßstabseitig periodischen Anordnung der ersten Teilbereiche TB1 mit der Grob-Teilungsperiode $TP_G$ ist es neben der Erzeugung von Absolutpositionssignalen POS in der erläuterten Art und Weise möglich, darüberhinaus auch ein periodisches Grob-Inkrementalsignal $INC_G$ zu erzeugen. Das Grob-Inkrementalsignal $INC_G$ besitzt eine Signalperiode $SP_G$, die sich in bekannter Art und Weise aus der Grob-Teilungsperiode $TP_G$ der ersten Teilbereiche TB1 auf dem Maßstab 10 ableitet. Das derart erzeugte Grob-Inkrementalsignal $INC_G$ lässt sich dann in bekannter Art und Weise mit dem Absolutpositionssignal POS zu einem höher auflösenden absoluten Positionswert $POS_{ABS}$ kombinieren. Zur Erzeugung des Grob-Inkrementalsignales $INC_G$ ist keine weitere Detektoranordnung erforderlich, hierzu kann vielmehr auch die oben erläuterte Detektoranordnung 2 mit den periodisch in Messrichtung angeordneten Detektorelementen 2.1 - 2.12 herangezogen werden, die dann entsprechend verschaltet werden und ausgangsseitig das Grob-Inkrementalsignal $INC_G$ liefern.

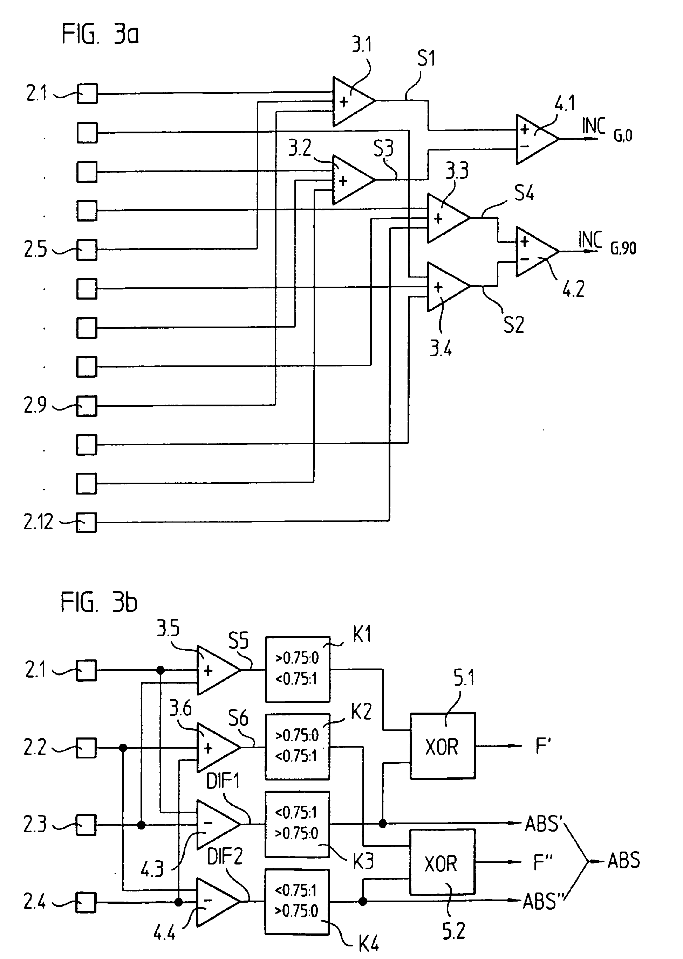

Eine mögliche Verschaltungsvariante für die Detektorelemente 2.1 - 2.12 des Beispieles aus Figur 2 ist in den Figuren 3A und 3B schematisch dargestellt. Die beiden Figuren 3A und 3B zeigen hierbei jeweils die erforderliche Verschaltung zur Erzeugung des Grob-Inkrementalsignales $INC_G$ sowie die Verschaltung zur Erzeugung des Absolutpositionssignales ABS. Lediglich aus Gründen der Übersichtlichkeit erfolgte die Darstellung der Verschaltungsvarianten in getrennten Figuren.

Mit den Bezugszeichen 3.1 - 3.4 sind in Figur 3A jeweils Summationselemente bezeichnet, die Abtastsignale phasengleicher Detektorelemente 2.1 - 2.12 zu den Summensignale S1 - S4 aufsummieren; mit den Bezugszeichen 4.1, 4.2 werden Differenzbildungselemente bezeichnet, die aus den vier Summensignalen S1 - S4 in bekannter Art und Weise die beiden, um 90° phasenversetzten Grob-Inkrementalsignale $INC_{G,0}$ bzw. $INC_{G,90}$ erzeugen.

Zur Erzeugung des Absolutpositionssignales ABS ist gemäß Figur 3B zunächst vorgesehen, die Abtastsignale der Detektorelemente 2.1, 2.3 einem Summationselement 3.5 und die Abtastsignale der Detektorelemente 2.2, 2.4 einem Summationselement 3.6 zuzuführen, die ausgangsseitig die Summensignale S5, S6 liefern. Desweiteren erfolgt über die Differenzbildungselemente D1, D2 die Erzeugung von Differenzsignalen DIF1, DIF2 aus den Abtastsignalen der Detektorelemente 2.1, 2.3 sowie 2.2, 2.4. Die Summen- und Differenzsignale S5, S6, D1, D2 werden anschließend vier Bewertungselementen K1 - K4 zugeführt, die etwa als Komparatoren mit vorgegebenen Komparatorschwellen ausgebildet sind und in denen die angebenen Zuordnungen erfolgen. Zur Erzeugung des Absolutpositionssignales ABS ist lediglich die Bewertung der gebildeten Differenzsignale DIF1, DIF2 gemäß den oben erläuterten Vorschriften erforderlich. Über die beiden Bewertungselemente K3, K4 erfolgt daher die Überprüfung, ob das jeweilige Differenzsignal DIF1, DIF2 entweder im Wertebereich 0.75 < DIF1, DIF2 oder im Wertebereich 0.75 > DIF1, DIF2 liegt und die entsprechende Zuordnung bzw. Ausgabe des logischen Signales EINS (1) oder NULL (0) als Teil-Absolutpositionssignal ABS', ABS". Da im vorliegenden Beispiel pro Teilbereich TB1 - TB3 je zwei Detektorelemente angeordnet sind, werden zwei Teil-Absolutpositionssignale ABS', ABS" erzeugt, die im Fall der korrekten Auslesung als Absolutpositionssignal ABS weiterverarbeitet werden.

Um zu überprüfen, ob die Detektorelemente korrekt ausgewählt wurden, ist im vorliegenden Beispiel desweiteren die Erzeugung eines bzw. zweier Fehlersignale F', F" vorgesehen. Hierzu werden die Summensignale S5, S6 in den beiden Bewertungselementen K1, K2 gemäß den angegebenen Bedingungen bewertet und die von den Bewertungselementen K1, K2 gelieferten Ausgangssignale nachfolgend mit den erzeugten Teil-Absolutpositionssignalen ABS', ABS" der Bewertungselemente K3, K4 den Verknüpfungselementen 5.1, 5.2 zugeführt. Nach der dort erfolgenden XOR-Verknüpfung resultieren ausgangsseitig die Fehlersignale F', F", die Werte von 0 oder 1 annehmen können. Der Wert F' = 1 bzw. F" = 1 wird hierbei als korrekte Auswahl der Detektorelemente interpretiert, der Wert F' = 0 bzw. F" = 0 als fehlerhafte Auswahl der Detektorelemente.

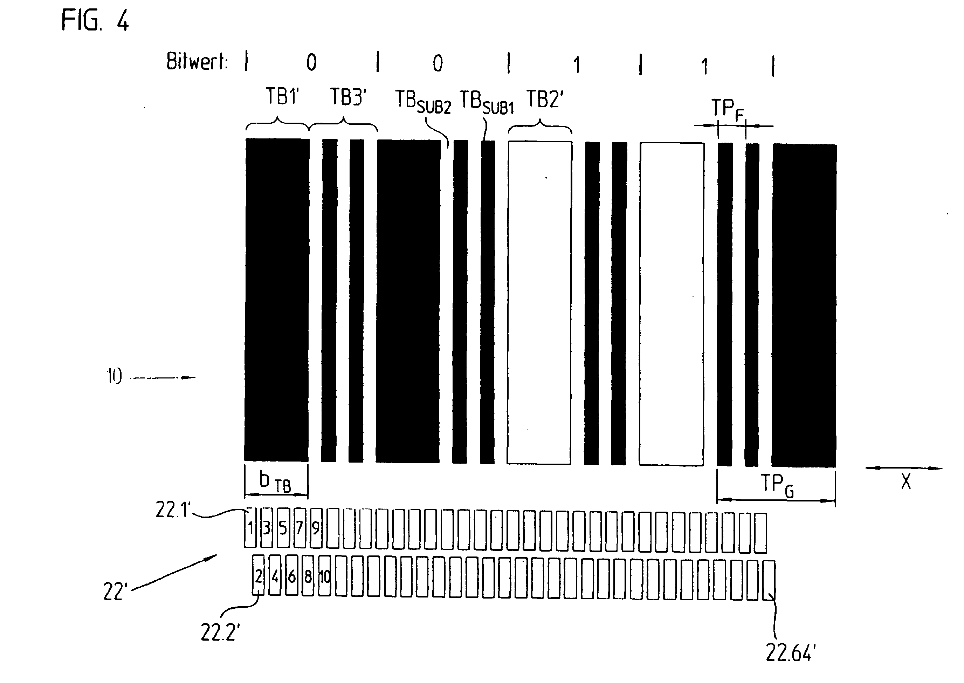

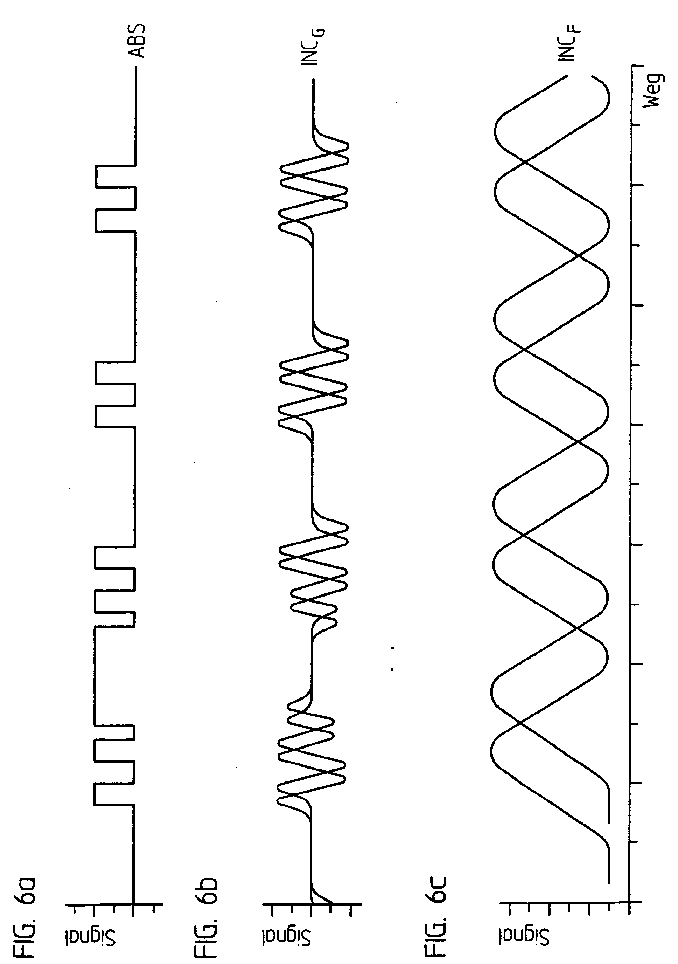

Ein weiteres Ausführungsbeispiel eines geeignet ausgebildeten Maßstabes inklusive der vorgesehenen Abtastung desselben sei nachfolgend anhand der Figuren 4, 5 sowie 6a - 6c erläutert.
In Figur 4 ist analog zur vorab beschriebenen Figur eine Draufsicht auf einen Teil eines Maßstabes 10' in Verbindung mit einer schematisch angedeuteten Detektoranordnung 22' gezeigt, welche in einer linearen Durchlicht-Positionsmesseinrichtung einsetzbar ist. Auf Seiten des Maßstabes sind wiederum erfindungsgemäß drei Teilbereiche TB1', TB2', TB3' mit unterschiedlichen optischen Eigenschaften entlang der Messrichtung x angeordnet. Die ersten und zweiten Teilbereiche TB1', TB2' sind wie im vorher erläuterten Beispiel vollständig opak bzw. vollständig durchlässig ausgebildet.

Unterschiedlich zum obigen Ausführungsbeispiel ist zum einen die Ausbildung der dritten Teilbereiche TB3' sowie zum anderen die Tatsache, dass nunmehr die dritten Teilbereiche TB3' in Messrichtung x periodisch entlang des Maßstabes 10' angeordnet sind. Die dritten Teilbereiche TB3' weisen in diesem Beispiel eine periodische Sub-Teilung auf, die wiederum aus in Messrichtung x periodisch angeordneten ersten und zweiten Sub-Teilbereichen $TB_{SUB1}$, $TB_{SUB2}$ mit unterschiedlichen optischen Eigenschaften bestehen. Die ersten und zweiten Sub-Teilbereiche $TB_{SUB1}$, $TB_{SUB2}$ sind im gezeigten Beispiel opak und vollständig durchlässig ausgebildet; die Periode der Anordnung der ersten und zweiten Sub-Teilbereiche $TB_{SUB1}$, $TB_{SUB2}$ sei nachfolgend als Fein-Teilungsperiode $TP_F$ bezeichnet und gibt in Messrichtung x die Ausdehnung aufeinanderfolgender erster und zweiter Sub-Teilbereiche $TB_{SUB1}$, $TB_{SUB2}$ an. Neben der Erzeugung eines Absolutpositionssignales ABS sowie eines Grob-Inkrementalsignales $INC_G$ analog zum vorherigen Beispiel gestattet diese Variante eines geeigneten Maßstabes 10' aufgrund der gewählten Ausbildung der dritten Teilbereiche TB3' ferner die Erzeugung eines Fein-Inkrementalsignales $INC_F$, dessen Auflösung höher als diejenige des Grob-Inkrementalsigales $INC_G$ ist. Die Bildung des absoluten Positionswertes $POS_{ABS}$ ist demzufolge mit nochmals gesteigerter Genauigkeit möglich.

Im Fall dieses Beispieles resultiert in Verbindung mit bestimmten - nachfolgend noch zu erläuternden abtastseitigen Dimensionierungsmaßnahmen - desweiteren eine sog. Einfeldabtastung bei der Erzeugung der verschiedenen Inkrementalsignale $INC_G$, $INC_F$. Hierunter ist eine Abtastung zu verstehen, bei der sämtliche phasenverschobenen Signalanteile der Inkrementalsignale $INC_G$ bzw. $INC_F$ aus der Abtastung einer einzigen Teilungsperiode $TP_G$ bzw. $TP_F$ auf dem Maßstab 10' resultieren. Als entscheidender Vorteil einer derartigen Abtastung ist deren Unempfindlichkeit gegenüber lokalen Maßstab-Verschmutzungen anzusehen, da dann stets alle erzeugten phasenverschobenen Teilsignale, die zu den verschiedenen Inkrementalsignalen $INC_G$, $INC_F$ beitragen, gleichmäßig beeinflusst werden.

Grundsätzlich ist die nachfolgende Beziehung (2) für das Verhältnis aus Grob-Teilungsperiode $TP_G$ und Fein-Teilungsperiode $TP_F$ auf Seiten des Maßstabes 10' einzuhalten:

$$TP_F = 1/n * \tfrac{1}{2} * TP_G \qquad \text{(Gl. 2),}$$

mit n = 1, 2, 3, ...

Neben der Erzeugung eines Absolutpositionssignales ABS gestattet der Maßstab in Verbindung mit bestimmten abtastseitigen Maßnahmen - die nachfolgend noch erläutert werden - wie bereits erwähnt die Erzeugung eines Grob-Inkrementalsignales $INC_G$ sowie eines Fein-Inkrementalsignales $INC_F$. Nachfolgend sei der Einfachheit halber stets von einem Grob- bzw. einem Fein-Inkrementalsignal $INC_G$ bzw. $INC_F$ die Rede, wenngleich in der Praxis üblicherweise jeweils ein Paar derartiger Signale erzeugt wird, die einen Phasenversatz von 90° zueinander besitzen.

Das Grob-Inkrementalsignal $INC_G$ resultiert wie im vorherigen Beispiel aus der Abtastung der mit der Grob-Teilungsperiode $TP_G$ periodisch angeordneten Teilbereiche TB3' auf dem Maßstab 10', wobei in diesem Fall nunmehr die dritten Teilbereiche TB3' entsprechend periodisch angeordnet werden. Das Fein-Inkrementalsignal $INC_F$ wird durch die Abtastung der Sub-Teilungsstruktur in den dritten Teilbereichen TB3' erzeugt, wo eine periodische Anordnung von Sub-Teilbereichen mit der Fein-Teilungsperiode $TP_F$ vorliegt.

Neben dem Absolutpositionssignal ABS stehen in dieser Variante somit zwei Inkrementalsignale $INC_G$, $INC_F$ unterschiedlicher Auflösung zur Weiterverarbeitung und Bildung eines absoluten Positionswertes $POS_{ABS}$ mit hoher Auflösung zur Verfügung. Im Beispielfall einer auf Seiten des Maßstabes 10' gewählten Grob-Teilungsperiode $TP_G$ = $160\mu m$ sowie einer Fein-Teilungsperiode $TP_F$ = $20\mu m$ ergeben sich bei einer entsprechenden Abtastung Grob-Inkrementalsignale $INC_G$ mit der Signalperiode $SP_G$ = $160\mu m$ bzw. Fein-Inkrementalsignale $INC_F$ mit der Signalperiode $SP_F$ = $20\mu m$. In diesem Beispiel ist die Größe n aus Gl. (2) demzufolge n = 4 gewählt.

Zur Erzeugung der verschiedenen Abtastsignale ABS, $INC_F$ und $INC_G$ sind auf Seiten der Abtasteinheit, insbesondere in Verbindung mit der Ausbildung bzw. Dimensionierung der Detektoranordnung 22' bestimmte Maßnahmen in der erfindungsgemäßen Positionsmesseinrichtung erforderlich, die nachfolgend erläutert werden.

Wie aus Figur 4 ersichtlich, umfasst die eingesetzte Detektoranordnung 22' in diesem Beispiel insgesamt k = 64 einzelne Detektorelemente 22.1' - 22.64', die in der Messrichtung x periodisch angeordnet sind.

Um in diesem Beispiel die erwähnte Einfeldabtastung sicherzustellen, sind detektionsseitig pro Grob-Teilungsperiode $TP_G$ insgesamt N = 16 Detektorelemente angeordnet. Im allgemeinen Fall einer gewünschten Einfeldabtastung, bei der pro abgetasteter Teilungsperiode vier um 90° phasenversetzte Inkrementalsignale erzeugt werden sollen, sind gemäß folgender Beziehung

$$N = 4 * n \qquad Gl. (3),$$

mit n = 2, 3, .....

Detektorelemente pro Grob-Teilungsperiode $TP_G$ abtastseitig anzuordnen, wenn das Verhältnis der Grob- und Fein-Teilungsperiode gemäß Gl. (2) gewählt wurde. Eine derartige Dimensionierung gewährleistet sowohl die Einfeldabtastung bei der Erzeugung der Fein-Inkrementalsignale $INC_F$ als auch bei der Erzeugung der Grob-Inkrementalsignale $INC_G$.

Grundsätzlich sind zur Sicherstellung der Einfeldabtastung bei der vorgesehenen Erzeugung von vier phasenverschobenen Abtastsignalen aus einer einzigen Teilungsperiode demzufolge mindestens vier Detektorelemente pro Teilungsperiode anzuordnen. Dies bedeutet, dass im Fall der alleinigen Erzeugung eines Grob-Irikrementalsignales $INC_G$ gemäß dem obigen Beispiel demzufolge mindestens vier Detektorelemente pro Grob-Teilungsperiode $TP_G$ anzuordnen sind oder ein ganzzahliges Vielfaches hiervon. Im Fall der zusätzlichen Erzeugung eines Fein-Inkrementalsignales $INC_F$ ist analog hierzu sicherzustellen, dass pro Fein-Teilungsperiode $TP_F$ mindestens vier Detektorelemente in Messrichtung angeordnet werden oder ggf. ein ganzzahliges Vielfaches hiervon.

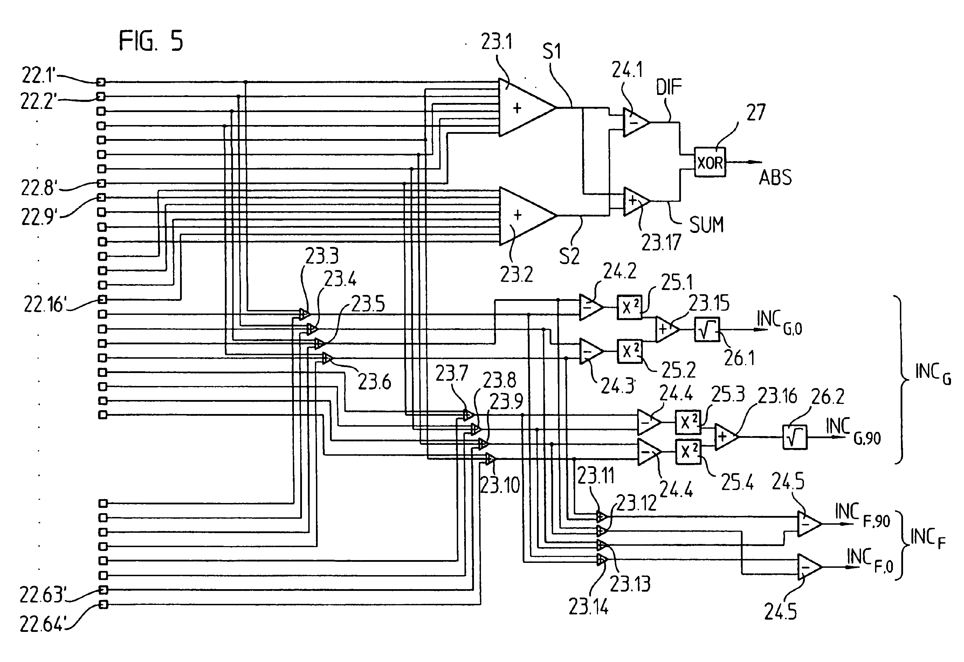

In Figur 5 ist die Verschaltung der Detektorelemente 22.1' - 22.64' innerhalb der Detektoranordnung 22 aus dem Beispiel der Figur 4 veranschaulicht, die zur Erzeugung der verschiedenen Abtastsignale ABS, $INC_G$ und $INC_F$ vorgesehen ist. Hierbei sind von den insgesamt zur Signalerzeugung eingesetzten k = 64 Detektorelementen 22.1' - 22.64' aus Gründen der Übersichtlichkeit lediglich ein Teil dargestellt.

Wie bereits oben erwähnt resultieren in der Praxis je ein Paar phasenversetzter Grob-Inkrementalsignale $INC_{G,0}$, $INC_{G,90}$, und Fein-Inkrementalsignale $INC_{F,0}$, $INC_{F,90}$, die bislang der Einfachheit halber jeweils als Grob-Inkrementalsignale $INC_G$ bzw. Fein-Inkrementalsignale $INC_F$ bezeichnet wurden.

Mit den Bezugzeichen 23.1 - 23.17 sind im Verschaltungsplan der Figur 5 jeweils Summationselemente bezeichnet, die eine Aufsummierung der jeweils eingangsseitig anliegenden Signale vornehmen. Über die mit den Bezugzeichen 24.1 - 24.5 bezeichneten Differenzbildungselemente erfolgt eine Subtraktion bzw. Differenzbildung der eingangs anliegenden Signale. Mithilfe der mit den Bezugzeichen 25.1 - 25.5 bzw. 26.1, 26.2 bezeichneten Elemente erfolgt die jeweils angegebene arithmetische Operation mit den anliegenden Eingangssignalen.

Zur Erzeugung der verschiedenen Abtastsignale ABS, $INC_G$ und $INC_F$ sind im vorliegenden Beispiel mindestens 16 Detektorelemente und die entsprechende Verschaltung derselben erforderlich, beispielsweise die Detektorelemente 22.1' - 22.16'. Die im Beispiel desweiteren vorgesehen zweiten bis vierten Blöcke mit jeweils 16 weiteren Detektorelementen 22.17' - 22.32', 22.33' - 22.48' und 22.49' - 22.64' liefern bei der Abtastung prinzipiell die identische Abtastinformation und verbessern lediglich die resultierende Signalstärke bei der Abtastung. Das heißt, jedes sechzehnte Detektorelement liefert die phasengleiche Abtast-Information.

Nachfolgend sei die Erzeugung des Absolutpositionssignales ABS im vorliegenden Beispiel erläutert. Der Erzeugung der beiden logischen Signale NULL (0) und EINS (1) liegen hierbei wieder bestimmte Zuordnungsregeln zugrunde. Den verschiedenen Teilbereichen TB1' - TB3' seien wiederum bestimmte Signalpegel zugeordnet gemäß

TB1': Signalpegel 0

TB2': Signalpegel 1

TB3': Signalpegel 0.5

Bestimmten, vorgegebenen Kombinationen aus zwei in Messrichtung x aufeinanderfolgenden Signalpegeln sind wiederum logische Signale NULL (0), EINS (1) zugeordnet, wobei in diesem Beispiel folgende Zuordnungsregeln gelten:

Signalpegel 0 - Signalpegel 0.5 $\Rightarrow$ logisches Signal NULL (0) (TB1' - TB3')
Signalpegel 1 - Signalpegel 0.5 $\Rightarrow$ logisches Signal EINS (1) (TB2' - TB3')

Um bei dieser Variante eines Maßstabes zu entscheiden, ob die Detektorelemente korrekt ausgewählt wurden, erfolgt neben der Bildung eines Differenzsignales DIF aus den Signalen benachbarter Teilbereiche zusätzlich noch die Bildung eines Summensignales SUM aus den Signalen benachbarter Teilbereiche. Die resultierenden Differenz- und Summensignale sind gemäß den folgenden Zuordnungsvorschriften den beiden logischen Signalen NULL (0) und EINS (1) zugeordnet:

Differenzsignal DIF = +0.5 $\Rightarrow$ logisches Signal EINS (1)
Differenzsignal DIF = -0.5 $\Rightarrow$ logisches Signal NULL (0)
Summensignal SUM = +1.5 $\Rightarrow$ logisches Signal EINS (1)
Summensignal SUM = +0.5 $\Rightarrow$ logisches Signal NULL (0)

Im Beispiel aufeinanderfolgender erster und dritter Teilbereiche TB1', TB3' resultiert das Differenzsignal DIF = -0.5 und das Summensignal SUM = +0.5. Gemäß den vorhergehenden Vorschriften ist beiden Signalen das logische Signal NULL zugeordnet, d.h. die Auswahl der Detektorelemente erfolgt korrekt. Im Fall aufeinanderfolgender dritter und erster Teilbereiche TB3', TB1' würde hingegen als Differenzsignal DIF = +0.5 und als Summensignal SUM = +0.5 resultieren; gemäß den obigen Vorschriften für die Zuordnung von Summen- und Differenzsignalen würde dies für das Differenzsignal DIF die Zuordnung des logischen Signales EINS (1) und für das Summensignal SUM die Zuordnung des logischen Signales NULL (0) bedeuten. Aus dieser Diskrepanz kann dann auf eine ggf. nicht korrekte Auswahl der Detektorelemente geschlossen werden. Ebenso wie im vorherigen Beispeil ist es demzufolge möglich, aus der Abtastung des Maßstabes festzustellen, ob die Detektorelemente korrekt ausgewählt wurden oder nicht.

Zur schaltungstechnischen Umsetzung werden in diesem Beispiel die resultierenden Abtastsignale der ersten acht Detektorelemente 22.1' - 22.8' über das Summationselement 23.1 zum Signal S1 aufsummiert, die Abtastsignale der zweiten acht Detektorelemente 22.9' - 22.16' über das zweite Summationselement 23.2 zum Signal S2. Aus den aufsummierten Signalen S1, S2 wird nachfolgend mit Hilfe des Differenzbildungselementes 24.1 das Differenzsignal DIF gebildet; mit Hilfe des Summationselementes 23.17 das Summensignal SUM. Das Summensignal SUM und das Differenzsignal werden darauf einem Verknüpfungselement 27 zugeführt, indem eine XOR-Verknüpfung der Signale DIF und SUM gemäß den vorher erläuterten Zuordnungsvorschriften erfolgt. Am Ausgang des Verknüpfungselementes 27 liegt dann das weiterverarbeitbare Absolutpositionssignal ABS bzw. die entsprechenden Bitwerte oder logischen Signale vor.

Zur Erzeugung des Grob-Inkrementalsignales $INC_G$ bzw. des Paares phasenversetzter Grob-Inkrementalsignales $INC_{G,0}$, $INC_{G,90}$ ist eine Verschaltung der Detektorelemente in der in Figur 5 dargestellten Art und Weise vorgesehen. An dieser Stelle sei in Bezug auf die gewählte Verschaltungsvariante lediglich erwähnt, dass die Auswahl der zu verschaltenden Detektorelemente in bekannter Art und Weise in Abhängigkeit von der Grob-Teilungsperiode $TP_G$ auf dem Maßstab erfolgt.

Ebenso sei im Zusammenhang mit der Erzeugung des Fein-Inkrementalsignales $INC_G$ bzw. des Paares phasenversetzter Fein-Inkrementalsignale $INC_{F,0}$, $INC_{F,90}$ lediglich auf die Verschaltung der Detektorelemente in der in Figur 4 dargestellten Art und Weise verwiesen. Auch hierbei richtet sich die Auswahl der zu verschaltenden Detektorelemente nach der Fein-Teilungsperiode $TP_F$ auf dem Maßstab.

Die aus einer derartigen Verschaltung der Detektorelemente 22.1 - 22.64 resultierenden Abtastsignale ABS, $INC_G$ und $INC_F$ bzw. die entsprechenden Signalpaare $INC_{F,0}$ und $INC_{F,90}$ ABS, $INC_{G,0}$ und $INC_F$ sind in den Figuren 5a - 5c dargestellt.

Im Rahmen der vorliegenden Erfindung sind selbstverständlich verschiedenste Modifikationen im Vergleich zu den bislang erläuterten Varianten denkbar.

So ist es etwa möglich, das zweite erläuterte Ausführungsbeispiel dahingehend abzuwandeln, dass auf Seiten der Abtasteinheit vor der Detektoranordnung ein Abtastgitter angeordnet wird, welches z.B. als Phasengitter ausgebildet ist. Mittels eines derartigen Abtastgitters lässt sich aufgrund der resultierenden Wechselwirkung mit der Fein-Teilungsperiode auf dem Maßstab in der Detektionsebene in bekannter Art und Weise eine sog. Vernierschwebung erzeugen. Aus dieser Vernierschwebung wiederum lässt sich ein Inkrementalsignal mit einer definierten Signalperiode ableiten.

Desweiteren sei erwähnt, dass selbstverständlich auch die Detektoranordnung, insbesondere die Zahl der eingesetzten Detektorelemente im Rahmen der obigen Überlegungen variiert werden können.

Neben den beschriebenen Beispielen existieren im Rahmen der vorliegenden Erfindung somit weitere Ausführungsalternativen.

**Patentansprüche**

1. Positionsmesseinrichtung, bestehend aus einem Maßstab (1; 10; 10') sowie einer relativ zum Maßstab (1; 10; 10') in einer Messrichtung (x) beweglichen Abtasteinheit (20), die aus der Abtastung des Maßstabes (1; 10; 10') die Absolutposition der Abtasteinheit (20) in Bezug auf den Maßstab (1; 10; 10') bestimmt, wobei der Maßstab aus einer Spur besteht, welche sich in mindestens einer Messrichtung erstreckt und in der Spur abwechselnd Teilbereiche gleicher Breite mit unterschiedlichen optischen Eigenschaften angeordnet sind und in der Spur mindestens erste, zweite und dritte Teilbereiche (TB1, TB2, TB3; TB1', TB2', TB3') mit unterschiedlichen optischen Eigenschaften angeordnet sind,
**dadurch gekennzeichnet, dass**
die Abtasteinheit einer ersten Kombination zweier aufeinanderfolgender, unterschiedlicher Teilbereiche (TB1, TB3; TB1', TB3') eindeutig ein erstes logisches Signal (1) zuordnet und einer zweiten Kombination zweier aufeinanderfolgender, unterschiedlicher Teilbereiche (TB2, TB3; TB2', TB3') eindeutig ein zweites logisches Signal (0) zuordnet, wobei sich die erste und die zweite Kombination voneinander unterscheiden.

2. Positionsmesseinrichtung nach Anspruch 1, **dadurch gekennzeichnet, dass** einer der Teilbereiche (TB3; TB3') in Messrichtung (x) periodisch auf dem Maßstab (10) mit einer Grob-Teilungsperiode (TP_G) angeordnet ist.

3. Positionsmesseinrichtung nach Anspruch 2, **dadurch gekennzeichnet, dass** die Grob-Teilungsperiode (TP_G) der doppelten Breite (b_TB) der Teilbereiche (TB1, TB2, TB3; TB1', TB2', TB3') mit unterschiedlichen optischen Eigenschaften entspricht.

4. Positionsmesseinrichtung nach Anspruch 1, **dadurch gekennzeichnet, dass** die ersten und zweiten Teilbereiche (TB1, TB2; TB1', TB2') zueinander komplementäre optische Eigenschaften besitzen.

5. Positionsmesseinrichtung nach Anspruch 1, **dadurch gekennzeichnet, dass** aufeinanderfolgenden ersten und dritten Teilbereichen (TB1, TB3; TB1', TB3') das erste logische Signal (1) zugeordnet ist und aufeinanderfolgenden zweiten und dritten Teilbereichen (TB2, TB3; TB2', TB3') das zweite logische Signal (0) zugeordnet ist.

6. Positionsmesseinrichtung nach Anspruch 1, **dadurch gekennzeichnet, dass** eine Abfolge mehrerer logischer Signale (0, 1) eine eindeutige Absolutposition entlang der Messrichtung (x) charakterisiert.

7. Positionsmesseinrichtung nach Anspruch 4, **dadurch gekennzeichnet, dass** die dritten Teilbereiche (TB3) eine optische Eigenschaft besitzen, die zwischen den Eigenschaften der beiden komplementären Eigenschaften der ersten und zweiten Teilbereiche (TB1, TB2) liegt.

8. Positionsmesseinrichtung nach Anspruch 7, **dadurch gekennzeichnet, dass** die dritten Teilbereiche (TB3) halbdurchlässig ausgebildet sind.

9. Positionsmesseinrichtung nach Anspruch 4, **dadurch gekennzeichnet, dass** die dritten Teilbereiche (TB3) eine periodische Sub-Teilung mit einer Fein-Teilungsperiode (TP_F) aufweisen, die aus periodisch angeordneten Sub-Teilbereichen (TB_SUB1, TB_SUB2) mit unterschiedlichen optischen Eigenschaften besteht.

10. Positionsmesseinrichtung nach Anspruch 9, **dadurch gekennzeichnet, dass** die Sub-Teilbereiche (TB_SUB1, TB_SUB2) zueinander komplementäre optische Eigenschaften besitzen.

11. Positionsmesseinrichtung nach Anspruch 3 und 9, **dadurch gekennzeichnet, dass** die Fein-Teilungsperiode (TP_F) gemäß der Beziehung

$$TP_F = 1/n * \tfrac{1}{2} * TP_G$$

gewählt ist, mit n = 1, 2, 3, ...

12. Positionsmesseinrichtung nach Anspruch 4 oder 10, **dadurch gekennzeichnet, dass** die zueinander komplementären optischen Eigenschaften folgendermaßen gewählt sind:

    - opak / vollständig durchlässig oder
    - reflektierend / nicht reflektierend

13. Positionsmesseinrichtung nach Anspruch 1, **dadurch gekennzeichnet, dass** die Abtasteinheit (20) mindestens eine Lichtquelle (21) sowie eine Detektoranordnung (2; 22; 22') zur Abtastung des Maßstabs (1; 10; 10') umfasst, wobei die Detektoranordnung (2; 22; 22') sowohl zur Erzeugung eines Absolutpositionssignales (ABS) als auch eines Grob-Inkrementalsignales (INC_G) dient.

14. Positionsmesseinrichtung nach Anspruch 1, **dadurch gekennzeichnet, dass** die Detektoranordnung (2; 22; 22') eine in Messrichtung (x) periodische Anordnung einzelner Detektorelemente (22.1 - 22.k; 2.1 - 2.6; 22.1' - 22.64') umfasst.

15. Positionsmesseinrichtung nach Anspruch 13 und 14, **dadurch gekennzeichnet, dass** in Messrichtung (x) pro Grob-Teilungsperiode (TP$_G$) mindestens vier Detektorelemente (2.1 - 2.12) angeordnet sind .

16. Positionsmessinrichtung nach Anspruch 13, **dadurch gekennzeichnet, dass** die Detektoranordnung (22') ferner zur Erzeugung eines Fein-Inkrementalsignales (INC$_F$) dient.

17. Positionsmesseinrichtung nach Anspruch 14 und 16, **dadurch gekennzeichnet, dass** in Messrichtung (x) pro Fein-Teilungsperiode mindestens vier einzelne Detektorelemente (22.1' - 22.64') angeordnet sind.

18. Positionsmesseinrichtung nach Anspruch 13, **dadurch gekennzeichnet, dass** in der Abtasteinheit vor der Detektoranordnung ein Abtastgitter angeordnet ist.


**Claims**

1. A position measuring device, consisting of a measurement scale (1; 10; 10') and a scanning unit (20) that moves relative to the measurement scale (1; 10; 10') in a measuring direction (x), which from the scanning of the measurement scale (1; 10; 10') determines the absolute position of the scanning unit (20) with reference to the measurement scale (1; 10; 10'), wherein
the measurement scale consists of a track, which extends in at least one measurement direction, and alternating partial regions of equal width with differing optical properties are arranged in the track, and at least first, second and third partial regions (TB1, TB2, TB3; TB1', TB2', TB3') with differing optical properties are arranged in the track,
**characterised in that** the scanning unit unambiguously assigns a first logical signal (1) to a first combination of two sequential differing partial regions (TB1, TB3; TB1', TB3') and unambiguously assigns a second logical signal (0) to a second combination of two sequential differing partial regions (TB2, TB3; TB2' TB3'), wherein
the first and the second combination differ from one another.

2. The position measuring device according to Claim 1, **characterised in that** one of the partial regions (TB3; TB3') is arranged periodically in a measurement direction (x) on the measurement scale (10) with a coarse pitch interval (TP$_G$).

3. The position measuring device according to Claim 2, **characterised in that** the coarse pitch interval (TP$_G$) corresponds to the double width (b$_{TB}$) of the partial regions (TB1, TB2, TB3; TB1', TB2', TB3') with differing optical properties.

4. The position measuring device according to Claim 1, **characterised in that** the first and second partial regions (TB1, TB2, TB1', TB2') possess optical properties that are complementary to one another.

5. The position measuring device according to Claim 1, **characterised in that** the first logical signal (1) is assigned to the sequential first and third partial regions are (TB1, TB3; TB1', TB3') and the second logical signal (0) is assigned to the sequential second and third partial regions (TB2, TB3; TB2', TB3').

6. The position measuring device according to Claim 1, **characterised in that** a sequence of a plurality of logical signals (0, 1) characterises an unambiguous absolute position along the measurement direction (x).

7. The position measuring device according to Claim 4, **characterised in that** the third partial regions (TB3) possess an optical property that lies between the properties of the two complementary properties of the first and second partial regions (TB1, TB2).

8. The position measuring device according to Claim 7, **characterised in that** the third partial regions (TB3) are designed to be semitransparent.

9. The position measuring device according to Claim 4, **characterised in that** the third partial regions (TB3) have a periodic sub-pitch with a fine pitch interval (TP$_F$), which consists of periodically arranged sub-partial regions (TB$_{SUB1}$, TB$_{SUB2}$) with differing optical properties.

10. The position measuring device according to Claim 9, **characterised in that** the sub-partial regions (TB$_{SUB1}$, TB$_{SUB2}$) possess optical properties that are complementary to one another.

11. The position measurement device according to Claims 3 and 9,
**characterised in that** the fine pitch interval (TP$_F$) is selected according to the relationship

$$TP_F = 1/n * \tfrac{1}{2} * TP_G$$

where n = 1, 2, 3, ...

12. The position measurement device according to Claim 4 or 10,
**characterised in that** the optical properties that are complementary to one another are selected in the following manner:

- opaque / completely transparent, or
- reflecting / non-reflecting.

**13.** The position measuring device according to Claim 1, **characterised in that** the scanning unit (20) comprises a light source (21) and also a detector arrangement (2; 22; 22') for scanning the measurement scale (1; 10; 10'), wherein

the detector arrangement (2; 22; 22') serves for the generation of both an absolute position signal (ABS) and also a coarse incremental signal ($INC_G$).

**14.** The position measuring device according to Claim 1, **characterised in that** the detector arrangement (2; 22; 22') comprises a periodic arrangement of individual detector elements (22.1 - 22.k; 2.1 - 2.6; 22.1' - 22.64') in a measurement direction (x).

**15.** The position measurement device according to Claims 13 and 14,

**characterised in that** at least four detector elements (2.1 - 2.12) are arranged in a measurement direction (x) per coarse pitch interval ($TP_G$) .

**16.** The position measuring device according to Claim 13,

**characterised in that** the detector arrangement (22') further serves for the generation of a fine incremental signal ($INC_F$).

**17.** The position measuring device according to Claims 14 and 16,

**characterised in that** at least four individual detector elements (22.1' -22.64') are arranged in a measurement direction (x) per fine pitch interval.

**18.** The position measuring device according to Claim 13,

**characterised in that** a scanning grating is arranged in the scanning unit in front of the detector arrangement.


**Revendications**

**1.** Dispositif de mesurage de position, constitué d'une échelle (1; 10; 10') ainsi que d'une unité de détection (20) déplaçable dans une direction de mesurage (x) par rapport à l'échelle (1 ; 10 ; 10'), unité qui détermine la position absolue de l'unité de détection (20) par rapport à l'échelle (1 ; 10 ; 10'), à partir de la détection de l'échelle (1 ; 10 ; 10'), l'échelle étant constituée d'une voie s'étendant au moins dans une direction de mesurage, et des régions partielles de même largeur avec des propriétés optiques différentes étant disposées de façon alternative dans la voie, et une première, une deuxième et une troisième régions partielles (TB1, TB2, TB3 ; TB1', TB2', TB3') au moins avec des propriétés optiques différentes étant disposées dans la voie,

**caractérisé en ce que**

l'unité de détection attribue de façon univoque un premier signal logique (1) à une première combinaison de deux régions partielles différentes consécutives (TB1, TB3; TB', TB3'), et un deuxième signal logique (0) à une deuxième combinaison de deux régions partielles différentes consécutives (TB2, TB3 ; TB2', TB3'), la première et la deuxième combinaisons étant différentes l'une de l'autre.

**2.** Dispositif de mesurage de position selon la revendication 1, **caractérisé en ce que** l'une des régions partielles (TB3; TB3') dans la direction de mesurage (x) est disposée périodiquement sur l'échelle (10) avec une période de division grossière ($TP_G$).

**3.** Dispositif de mesurage de position selon la revendication 2, **caractérisé en ce que** la période de division grossière ($TP_G$) correspond à la double largeur ($b_{TB}$) des régions partielles (TB1, TB2, TB3 ; TB1', TB2', TB3') avec des propriétés optiques différentes.

**4.** Dispositif de mesurage de position selon la revendication 1, **caractérisé en ce que** les premières et deuxièmes régions partielles (TB1, TB2 ; TB1', TB2') présentent des propriétés optiques complémentaires entre elles.

**5.** Dispositif de mesurage de position selon la revendication 1, **caractérisé en ce que** le premier signal logique (1) est attribué aux premières et troisièmes régions partielles (TB1, TB3; TB1', TB3') consécutives, et **en ce que** le deuxième signal logique (0) est attribué aux deuxièmes et troisièmes régions partielles (TB2, TB3 ; TB2', TB3') consécutives.

**6.** Dispositif de mesurage de position selon la revendication 1, **caractérisé en ce que** une suite de plusieurs signaux logiques (0, 1) caractérise une position absolue évidente le long de la direction de mesurage (x).

**7.** Dispositif de mesurage de position selon la revendication 4, **caractérisé en ce que** les troisièmes régions partielles (TB3) présentent une propriété optique se trouvant entre les deux propriétés complémentaires des premières et deuxièmes régions partielles (TB1, TB2).

**8.** Dispositif de mesurage de position selon la revendication 7, **caractérisé en ce que** les troisièmes régions partielles (TB3) sont conçues de façon semi-transparente.

**9.** Dispositif de mesurage de position selon la revendication 4, **caractérisé en ce que** les troisièmes régions partielles (TB3) comportent une sous-division périodique avec une période de division fine ($TP_F$), qui est constituée de sous-régions partielles ($TB_{SUB1}$, $TB_{SUB2}$) disposées de façon périodique avec des propriétés optiques différentes.

**10.** Dispositif de mesurage de position selon la revendication 9, **caractérisé en ce que** les sous-régions partielles ($TB_{SUB1}$, $TB_{SUB2}$) présentent des propriétés optiques complémentaires entre elles.

**11.** Dispositif de mesurage de position selon les revendications 3 et 9, **caractérisé en ce que** la période de division fine ($TP_F$) est choisie conformément à la relation suivante :

$$TP_F = 1/n * \tfrac{1}{2} * TP_G$$

avec n = 1, 2, 3, ...

**12.** Dispositif de mesurage de position selon l'une des revendications 4 ou 10, **caractérisé en ce que** les propriétés optiques complémentaires entre elles sont choisies de la manière suivante :

- opaque / complètement transparent, ou
- réfléchissant / non réfléchissant.

**13.** Dispositif de mesurage de position selon la revendication 1, **caractérisé en ce que** l'unité de détection (20) comprend au moins une source de lumière (21) ainsi qu'un ensemble de détection (2 ; 22 ; 22') pour la détection de l'échelle (1 ; 10 ; 10'), l'ensemble de détection (2 ; 22 ; 22') servant aussi bien à la production d'un signal de position absolue (ABS) qu'à la production d'un signal incrémental grossier ($INC_G$)

**14.** Dispositif de mesurage de position selon la revendication 1, **caractérisé en ce que** l'ensemble de détection (2 ; 22 ; 22') comprend une disposition périodique d'éléments de décoration séparés (22.1 - 22.k ; 2.1 - 2.6 ; 22.1' - 22.64') dans la direction de mesurage (x).

**15.** Dispositif de mesurage de position selon les revendications 13 et 14, **caractérisé en ce qu'**au moins quatre éléments de décoration (2.1 - 2.12) sont disposés par période de division grossière ($TP_G$) dans la direction de mesurage (x).

**16.** Dispositif de mesurage de position selon la revendication 13, **caractérisé en ce que** l'ensemble de détection (22') sert par ailleurs à produire un signal incrémental fin ($INC_F$).

**17.** Dispositif de mesurage de position selon les revendications 14 et 16, **caractérisé en ce qu'**au moins quatre éléments de décoration (22.1' - 22.64') séparés sont disposés par période de division fine dans la direction de mesurage (x).

**18.** Dispositif de mesurage de position selon la revendication 13, **caractérisé en ce qu'**une grille de détection est disposée avant l'ensemble de détection dans l'unité de détection.

EP 1 329 696 B1

FIG. 1

21 ⊗

23

10

X

20

22  22.1  22.2 . . . . . . . .  22.K

13

FIG. 2

Bitwert:    | 1 | 1 | 0 | 0 |

TB3  TB1        TB2        X

10

$b_{DET}$

$b_{TB}$

$TP_G$

2

2.1  2.2  2.3  2.4  2.5  2.6  2.7  2.8  2.9  2.10  2.11  2.12

EP 1 329 696 B1

FIG. 3a

FIG. 3b

FIG. 4

EP 1 329 696 B1

FIG. 5

FIG. 6a

Signal

ABS

FIG. 6b

Signal

INC$_G$

FIG. 6c

Signal

INC$_F$

Weg

EP 1 329 696 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0635700 A1
- GB 2297840 A
- US 4774494 A

**In der Beschreibung aufgeführte Nicht-Patentliteratur**

- **J. T. M. STEVENSON ; J. R. JORDAN.** Absolute position measurement using optical detection of coded patterns. *J. Phys. E: Sci. Instrum.,* 1988, vol. 21, 1140-1145